# EUROPÄISCHE PATENTANMELDUNG

(11) **EP 3 056 724 A1**
(43) Veröffentlichungstag der Anmeldung: **17.08.2016**
(21) Anmeldenummer: 15202928.6
(22) Anmeldetag: 29.12.2015
(51) Int. Cl.: F02M 57/00, H01L 41/083, H01L 41/113, H01L 41/273

(54) **KRAFTSTOFFINJEKTOR UND VERFAHREN ZUR HERSTELLUNG EINES PIEZOELEMENTS FÜR EINEN KRAFTSTOFFINJEKTOR**

(30) Priorität: 16.02.2015 DE 102015202725
(71) Anmelder: ROBERT BOSCH GMBH, 70442 Stuttgart (DE)
(72) Erfinder: Cromme, Peter, 96050 Bamberg (DE)

(57) **Zusammenfassung**

Die Erfindung betrifft einen Kraftstoffinjektor (10), insbesondere Common-Rail-Injektor, mit einem Injektorgehäuse (11), in dem ein Hochdruckraum (15) ausgebildet ist, der über eine im Injektorgehäuse (11) angeordnete Versorgungsbohrung (19) mit unter Druck stehendem Kraftstoff versorgbar ist, mit wenigstens einer zumindest mittelbar mit dem Hochdruckraum (15) verbundenen, im Injektorgehäuse (11) ausgebildeten Einspritzöffnung (12) zum Einspritzen von Kraftstoff in den Brennraum einer Brennkraftmaschine, mit einem die wenigstens eine Einspritzöffnung (12) freigebenden oder verschließenden Einspritzglied (16), und mit einer Messeinrichtung (30) zur zumindest mittelbaren Erfassung des Drucks im Hochdruckraum (15) oder der Versorgungsbohrung (19), wobei die Messeinrichtung (30) dazu ausgebildet ist, eine elastische Verformung eines zumindest mittelbar mit der Versorgungsbohrung (19) oder dem Hochdruckraum (15) in Wirkverbindung angeordneten Verformungsbereichs (27) des Injektorgehäuses (11) zu erfassen, wobei die Messeinrichtung (30) ein Piezoelement (31) aufweist, und wobei das Piezoelement (31) wenigstens zwei Elektrodenschichten (34, 35) mit dazwischen angeordneter Piezokeramikschicht (36) aufweist. Erfindungsgemäß ist es vorgesehen, dass mehrere, vorzugsweise zwischen 10 und 100 übereinander angeordnete und parallel zueinander ausgerichtete Elektrodenschichten (34, 35) mit jeweils dazwischen angeordneten Piezokeramikschichten (36) vorgesehen sind, und dass die gegenüberliegenden Stirnseiten des Piezoelements (31) mit jeweils einer Isolationsschicht (37, 38) versehen sind.

## Beschreibung

### Stand der Technik

Die Erfindung betrifft einen Kraftstoffinjektor nach dem Oberbegriff des Anspruchs 1. Ferner betrifft die Erfindung ein Verfahren zur Herstellung eines Piezoelements für einen erfindungsgemäßen Kraftstoffinjektor nach dem Oberbegriff des Verfahrensanspruchs.

Aus der nachveröffentlichten DE 10 2014 209330 A1 der Anmelderin ist ein Kraftstoffinjektor bekannt, der im Bereich seines Haltekörpers des Injektorgehäuses eine Messeinrichtung aufweist, die dazu dient, zumindest indirekt die Stellung eines als Düsennadel ausgebildeten Einspritzglieds zu erfassen. Dadurch soll über die Lebens- bzw. Betriebsdauer des Kraftstoffinjektors betrachtet trotz ggf. auftretendem Verschleiß oder sonstigen Umständen eine stets optimale Anpassung der Steuerung des Einspritzglieds erzielt werden, damit eine mit entsprechenden Kraftstoffinjektoren ausgestattete Brennkraftmaschine beispielsweise stets optimale Abgaswerte erreichen kann. Hierzu ist es bei dem bekannten Kraftstoffinjektor vorgesehen, dass ein als Piezoelement ausgebildetes Sensorelement mit der Oberfläche des Injektorgehäuses über eine Klebeverbindung gekoppelt ist. Der Anbauort des Piezoelements befindet sich in der Nähe einer einen Hochdruckraum des Kraftstoffinjektors mit unter Hochdruck stehendem Kraftstoff versorgenden Zulaufbohrung, in deren Bereich die Wanddicke des Injektorgehäuses reduziert ist. Dadurch wird am Injektorgehäuse ein Verformungsbereich ausgebildet, der sich umso mehr elastisch nach außen wölbt, je größer der Kraftstoffdruck in der Zulaufbohrung ist. Im Bereich des Verformungsbereichs werden in Abhängigkeit von der Verformung Dehnungen bzw. Zugspannungen erzeugt und über die Klebstoffschicht in das Piezoelement eingekoppelt, was zu entsprechenden Spannungssignalen des Piezoelements führt, die mittels einer Auswerteschaltung ausgewertet werden können, um damit auf den Kraftstoffdruck in der Versorgungsbohrung und dadurch wiederum auf den Schließ- und Öffnungszeitpunkt bzw. die Stellung der Düsennadel zu schließen. Das bei dem bekannten Kraftstoffinjektor verwendete Piezoelement besteht aus einer Piezokeramik, die an den beiden Stirnflächen von jeweils einer Elektrodenschicht überdeckt ist. Nachteilig dabei ist, dass mittels eines derartigen Piezoelements nur ein relativ geringes Spannungssignal bei einer Deformation des Verformungsbereichs erzeugbar ist. Dies hat zur Folge, dass zur Erzielung einer gewünschten hohen Auflösung ggf. aufwändige (elektronische) Schaltungen oder ähnliches erforderlich sind.

### Offenbarung der Erfindung

Ausgehend von dem dargestellten Stand der Technik liegt der Erfindung die Aufgabe zugrunde, einen Kraftstoffinjektor nach dem Oberbegriff des Anspruchs 1 derart weiterzubilden, dass gegenüber dem Stand der Technik unter Beibehaltung eines in Bezug auf seine Grundfläche kompakt bauenden Piezoelements bei einer bestimmten Deformation des Verformungsbereichs bzw. einer bestimmten Druckänderung im Kraftstoffinjektor ein erhöhtes Spannungssignal ohne aufwändige elektronische Schaltungen oder ähnliche Maßnahmen erzielbar ist.

Diese Aufgabe wird erfindungsgemäß bei einem Kraftstoffinjektor mit den kennzeichnenden Merkmalen des Anspruchs 1 dadurch gelöst, dass zur Ausbildung des Piezoelements mehrere, vorzugsweise zwischen 10 und 100 übereinander und parallel zueinander ausgerichtete Elektrodenschichten mit dazwischen angeordneten Piezokeramikschichten vorgesehen sind, und dass die gegenüberliegenden Stirnseiten des Piezoelements mit jeweils einer Isolationsschicht überdeckt sind. Eine derartige erfindungsgemäße Ausbildung der Messeinrichtung bzw. des Piezoelements bewirkt aufgrund der Vielzahl der Elektrodenschichten mit dazwischenliegenden Piezokeramikschichten ein gegenüber dem Stand der Technik deutlich erhöhtes Spannungssignal am Piezoelement bei einem bestimmten Kraftstoffdruck bzw. bei einer bestimmten Deformation im Verformungsbereich. Gleichzeitig ist der Bauraum des Piezoelements in Bezug auf dessen Grundfläche gegenüber dem Stand der Technik nicht vergrößert.

Vorteilhafte Weiterbildungen des erfindungsgemäßen Kraftstoffinjektors sind in den Unteransprüchen aufgeführt. In den Rahmen der Erfindung fallen sämtliche Kombinationen aus zumindest zwei von in den Ansprüchen, der Beschreibung und/oder den Figuren offenbarten Merkmalen.

Zur Verringerung des Aufwands der elektrischen Kontaktierung der einzelnen Elektrodenschichten ist es von Vorteil, wenn die Elektrodenschichten gleicher Polarität jeweils mit einer gemeinsamen Anschlussleitung verbunden sind.

Hierzu ist es in einer Weiterbildung vorgesehen, dass die Elektrodenschichten gleicher Polarität im Verbindungsbereich zu den Anschlussleitungen in einer Ebene senkrecht zu den Elektrodenschichten zueinander fluchtend ausgerichtet sind. Mit anderen Worten gesagt bedeutet dies, dass die Elektrodenschichten gleicher Polarität in Draufsicht auf das Piezoelement in einem senkrecht zu den Elektrodenschichten angeordneten Verbindungsbereich verbindbar sind.

In bevorzugter geometrischer Dimensionierung ist es vorgesehen, dass die Dicke einer aus zwei Elektrodenschichten und dazwischenliegender Piezokeramikschicht gebildeten Einheit zwischen 20µm und etwa 300µm beträgt.

Der Querschnitt bzw. die Form des Piezoelements bzw. der Elektrodenschichten kann in unterschiedlichster Art und Weise ausgebildet bzw. einer entsprechenden Ausnehmung im Injektorgehäuse angepasst sein. Bevorzugt ist jedoch ein runder, kreissegment- oder rechteckförmiger Querschnitt bzw. eine entsprechende Grundfläche des Piezoelements.

Zur Ausbildung der Isolationsschichten an den beiden Stirnseiten des Piezoelements hat es sich als vorteilhaft herausgestellt, wenn diese aus demselben Grundmaterial bestehen wie das Piezoelement, da in diesem Fall eine besonders einfache Fertigung durch einen einstufigen Sinterprozess mit allen Bestandteilen (Piezoschichten und Isolationsschichten) möglich ist. Alternativ können die Isolationsschichten aus Aluminiumoxid bestehen. Aluminiumoxid hat bei hoher Isolationswirkung und hoher Festigkeit bzw. Steifigkeit einen negativen Wärmeausdehnungskoeffizienten und gleicht somit bei einer Temperaturerhöhung des Kraftstoffinjektors Eigenverformungen des Injektorgehäuses im Sinne einer Spannungsreduzierung am Piezoelement aus, die ansonsten beispielsweise über eine entsprechende Software kompensiert werden müssten.

Die Erfindung umfasst auch ein Verfahren zur Herstellung eines soweit beschriebenen Piezoelements für einen erfindungsgemäßen Kraftstoffinjektor, wobei das Piezoelement mehrere, vorzugsweise zwischen 10 und 100 übereinander angeordnete und parallel zueinander ausgerichtete Elektrodenschichten mit dazwischen angeordneten Piezokeramikschichten aufweist, und wobei die gegenüberliegenden Stirnseiten des Piezoelements mit jeweils einer Isolationsschicht überdeckt sind. Erfindungsgemäß ist es vorgesehen, dass die Piezokeramikschichten aus ungebrannten Keramikfolien hergestellt werden, die mit den Elektrodenschichten versehen und mittels Bindemitteln in einem Laminierprozess übereinander gestapelt werden, und dass anschließend durch eine Wärmebehandlung eine Entfernung des Bindemittels aus dem gestapelten Verbund und anschließend eine Versinterung der Piezokeramikschichten erfolgt. Ein derartiges erfindungsgemäßes Herstellverfahren ermöglicht eine besonders einfache und kostengünstige Herstellung eines Piezoelements.

Darüber hinaus ist es von Vorteil, wenn die Isolationsschichten zusammen mit den Piezokeramikschichten der Wärmebehandlung unterzogen und mit den Piezoelementen verbunden werden. Das bedeutet, dass die Isolationsschichten in ein und demselben Herstellprozess zusammen mit den Piezokeramikschichten und den Elektrodenschichten zur Ausbildung des Piezoelements verbunden werden. Dadurch lässt sich der Herstellprozess des Piezoelements weiter vereinfachen bzw. optimieren. Voraussetzung hierfür ist, dass die Materialeigenschaften der Piezokeramik und der Isolationsschichten eine derartige Verbindung ermöglichen.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine stark vereinfachte, teilweise geschnittene Seitenansicht eines erfindungsgemäßen Kraftstoffinjektors mit einer Messeinrichtung zur zumindest mittelbaren Erfassung des Verlaufs des Kraftstoffdrucks im Kraftstoffinjektor,
- Fig. 2: einen Längsschnitt durch die bei dem Kraftstoffinjektor gemäß Fig. 1 verwendete Messeinrichtung, wobei der Vereinfachung halber lediglich eine relativ geringe Anzahl von Piezo- und Elektrodenschichten dargestellt ist und
- Fig. 3: ein Ablaufdiagramm zur Verdeutlichung der wesentlichen Schritte zur Herstellung eines Piezoelements als Hauptbestandteil der Messeinrichtung gemäß Fig. 2.

Gleiche Elemente bzw. Elemente mit gleicher Funktion sind in den Figuren mit den gleichen Bezugsziffern versehen.

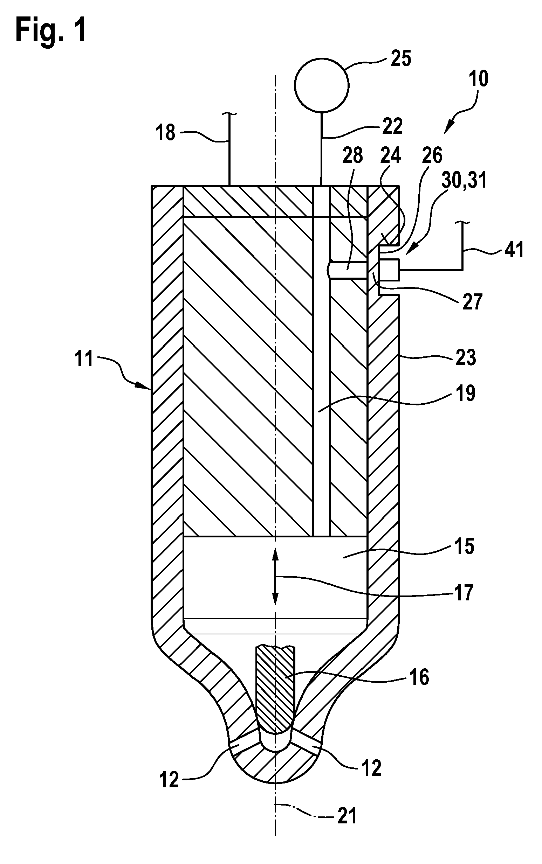

Der in der Fig. 1 stark vereinfacht dargestellte Kraftstoffinjektor 10 ist als sogenannter Common-Rail-Injektor ausgebildet, und dient dem Einspritzen von Kraftstoff in den nicht gezeigten Brennraum einer Brennkraftmaschine, insbesondere einer selbstzündenden Brennkraftmaschine.

Der Kraftstoffinjektor 10 weist ein im Wesentlichen aus Metall bestehendes, ggf. mehrteilig ausgebildetes Injektorgehäuse 11 auf, in dem auf der dem Brennraum der Brennkraftmaschine zugewandten Seite wenigstens eine, vorzugsweise mehrere Einspritzöffnungen 12 zum Einspritzen des Kraftstoffs in den Brennraum angeordnet sind. Innerhalb des Injektorgehäuses 11 weist dieses einen Hochruckraum 15 auf, in dem eine als Einspritzglied dienende Düsennadel 16 in Richtung des Doppelpfeils 17 hubbeweglich angeordnet ist. In der dargestellten, abgesenkten Stellung der Düsennadel 16 bildet diese zusammen mit der Innenwand des Hochdruckraums 15 bzw. des Injektorgehäuses 11 einen Dichtsitz aus, so dass die Einspritzöffnungen 12 zumindest mittelbar verschlossen sind, derart, dass ein Einspritzen von Kraftstoff aus dem Hochdruckraum 15 in den Brennraum der Brennkraftmaschine verhindert wird. In der anderen, nicht dargestellten, von dem Dichtsitz abgehobenen Position der Düsennadel 16 gibt diese die Einspritzöffnungen 12 zum Einspritzen des Kraftstoffs in den Brennraum der Brennkraftmaschine frei.

Die Bewegung der Düsennadel 16, insbesondere zum Freigeben der Einspritzöffnungen 12, erfolgt auf eine an sich bekannte Art und Weise mittels eines nicht dargestellten Aktuators, der über eine Spannungsversorgungsleitung 18 von einer Steuereinrichtung der Brennkraftmaschine ansteuerbar ist. Bei dem Aktuator kann es sich insbesondere um einen Magnetaktuator oder um einen Piezoaktuator handeln.

Die Versorgung des Hochdruckraums 15 mit unter Hochdruck (Systemdruck) stehendem Kraftstoff erfolgt über eine innerhalb des Injektorgehäuses 11 angeordnete bzw. in Bauteilen des Kraftstoffinjektors 10 ausgebildete Versorgungsbohrung 19, die insbesondere exzentrisch zur Längsachse 21 des Injektorgehäuses 11 in einem Randbereich des Kraftstoffinjektors 10, zumindest im Wesentlichen parallel zur Längsachse 21, verläuft. Die Versorgungsbohrung 19 ist darüber hinaus über einen nicht dargestellten Kraftstoffanschlussstutzen mit einer Kraftstoffleitung 22 verbunden, welche wiederum mit einem Kraftstoffspeicher 25 (Rail) gekoppelt ist.

In einem von den Einspritzöffnungen 12 bzw. dem Brennraum der Brennkraftmaschine axial relativ weit beabstandeten Bereich des Injektorgehäuses 11 ist in dessen Außenwand 23 beispielhaft eine sacklochförmige Vertiefung 24 ausgebildet, so dass die Wanddicke des Injektorgehäuses 11 im Bereich der Vertiefung 24 gegenüber dem die Vertiefung 24 unmittelbar umgebenden Bereich reduziert ist. Ergänzend wird erwähnt, dass anstelle einer sacklochförmigen Vertiefung 24 das Injektorgehäuse 11 auch eine Abflachung aufweisen kann, in deren Bereich die Wanddicke des Injektorgehäuses 11 reduziert ist.

Der eben ausgebildete Grund 26 der Vertiefung 24 bildet einen Teil eines Verformungsbereichs 27 aus. Auf der der Vertiefung 24 abgewandten Seite des Injektorgehäuses 11 ist in dem Injektorgehäuse 11 beispielhaft ein Abzweig 28 angeordnet, der wiederum in der Versorgungsbohrung 19 mündet. Dadurch wirkt der in der Versorgungsbohrung 19 augenblicklich herrschende Kraftstoffdruck auch in dem Abzweig 28 auf der der Vertiefung 24 abgewandten Seite des Injektorgehäuses 11. Dadurch, dass die Wanddicke des Injektorgehäuses 11 im Verformungsbereich 27 reduziert ist, wirkt dieser in Art einer elastisch verformbaren Membran, wobei sich eine Deformation des Verformungsbereichs 27 bei einer Erhöhung des Kraftstoffdrucks in dem Abzweig 28 als Wölbung ausbildet und umso größer ist, je höher der augenblickliche Kraftstoffdruck in der Versorgungsbohrung 19 bzw. in dem Abzweig 28 ist.

Zur Detektion des zeitlichen Verlaufs des Kraftstoffdrucks in dem Abzweig 28 bzw. in der Versorgungsbohrung 19 und damit auch in dem Hochdruckraum 15, welcher als Indiz für die augenblickliche Stellung der Düsennadel 16 zur Ansteuerung der Düsennadel 16 verwendet wird, weist der Kraftstoffinjektor 10 eine Messeinrichtung 30 auf. Die Messeinrichtung 30 umfasst ein als Piezoelement 31 ausgebildetes Sensorelement 32.

Das Piezoelement 31 kann beispielsweise durch eine nicht dargestellte Klebeverbindung auf dem Grund der Vertiefung 24 angeordnet bzw. mit diesem verbunden sein. Alternativ ist es auch denkbar, das Piezoelement 31 beispielsweise mittels eines (mechanischen) Hilfselements mit einer Vorspannkraft gegen den Grund der Vertiefung 24 zu drücken. Wesentlich ist lediglich, dass das Piezoelement 31 in Wirkverbindung mit dem Grund der Vertiefung 24 angeordnet ist, um über den Verformungsbereich 27 Deformationen, hervorgerufen durch Druckschwankungen des Kraftstoffs in dem Abzweig 28, zu erfassen.

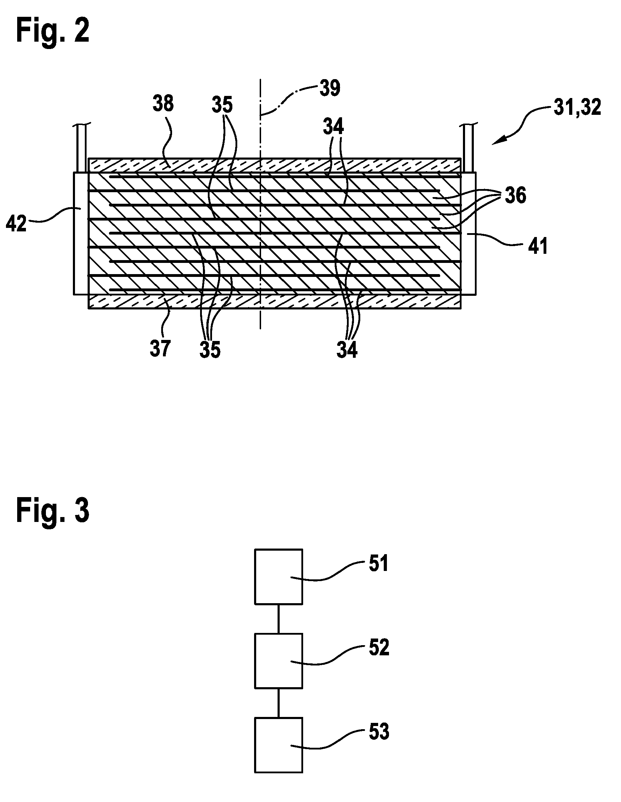

Entsprechend der Darstellung der Fig. 2 besteht des Piezoelement 31, welches in Draufsicht bzw. im Querschnitt vorzugsweise eine runde, kreissegment- oder rechteckförmige Form aufweist, aus einer Vielzahl von übereinander angeordneten Elektrodenschichten 34, 35 unterschiedlicher Polarität, wobei die Polarität der parallel zueinander angeordneten Elektrodenschichten 34, 35 abwechselt. Vorzugsweise weist das Piezoelement 31 zwischen 10 und 100 Elektrodenschichten 34, 35 auf. In der Fig. 2 sind aus Vereinfachungsgründen eine geringere Anzahl von Elektrodenschichten 34, 35 dargestellt. Zwischen den Elektrodenschichten 34, 35 ist jeweils eine aus keramischem Material bestehende Piezoschicht 36 angeordnet. Eine aus den Elektrodenschichten 34, 35 und Piezoschichten 36 bestehende Einheit weist eine Gesamthöhe zwischen etwa 20µm und 300µm auf. Die oberste und die unterste der Elektrodenschichten 34, 35 des Piezoelements 31 ist jeweils vorzugsweise vollflächig von einer Isolationsschicht 37, 38 überdeckt. Die beiden Isolationsschichten 37, 38 bestehen vorzugsweise aus demselben Grundmaterial wie die Piezoschichten 36, oder aber aus einem anderen Material, beispielsweise aus Aluminiumoxid.

Die jeweils gleiche Polarität aufweisenden Elektrodenschichten 34, 35 sind im dargestellten Ausführungsbeispiel auf gegenüberliegenden Seiten, d.h. um 180° in Bezug zu einer Längsachse 39 versetzt bis an den Rand des Piezoelements 31 herausgeführt. Dort sind die einen Elektrodenschichten 34 mit einer ersten Anschlussleitung 41, und die zweiten Elektrodenschichten 35 mit einer zweiten Anschlussleitung 42 elektrisch kontaktiert bzw. verbunden, über die die von dem Piezoelement 31 erzeugten Spannungssignale an eine Steuereinrichtung weiterleitbar sind .

Die Herstellung eines derartigen Piezoelements 31 bzw. eines Sensorelements 32 erfolgt entsprechend der Fig. 3 beispielhaft dadurch, dass in einem ersten Schritt 51 zunächst ungebrannte Keramikfolien einzeln strukturiert, gestapelt und mit den Elektrodenschichten 34, 35 bedruckt werden. Die Verbindung der übereinander gestapelten Keramikfolien erfolgt in einem Laminierprozess. Anschließend werden in einem zweiten Schritt 52 die beiden Isolationsschichten 37, 38 mit den jeweils äußeren Elektrodenschichten 34, 35 verbunden. Zuletzt erfolgt in einem dritten Schritt 53 eine Wärmebehandlung einer derartig ausgebildeten Baueinheit, bei der zunächst (bei steigender Temperatur) die Bindemittel diffundieren und anschließend die (zunächst) ungebrannten Keramikfolien bzw. Piezoschichten 36 versintern. Dabei bilden die Piezoschichten 36 sowie die Elektrodenschichten 34, 35 und die beiden Isolationsschichten 37, 38 einen festen Verbund aus, der anschließend mit den Anschlussleitungen 41, 42 verbunden werden kann. Zuletzt kann es vorgesehen sein, dass ein derartiger Verbund an seinem Umfang bzw. in radialer Richtung in Bezug auf die Längsachse 39 mit einer Isolierung (nicht dargestellt) versehen wird.

Der soweit beschriebene Kraftstoffinjektor 10 bzw. das Piezoelement 31 können in vielfältiger Art und Weise abgewandelt bzw. modifiziert werden, ohne vom Erfindungsgedanken abzuweichen. So ist es beispielsweise möglich, auf den Abzweig 28 zu verzichten und sattdessen lediglich eine Abflachung am Injektorgehäuse 11 vorzusehen, wenn ein hinreichend geringer Abstand zwischen der Versorgungsbohrung 19 und der Außenwand des Injektorgehäuses 11 besteht. Weiterhin wird ergänzt, dass für den Fall, dass die Isolationsschichten 37, 38 aus einem anderen (Grund-) Material bestehen wie die Piezoschichten 36, insbesondere aus Aluminiumoxid, eine Versinterung der Isolationsschichten 37, 38 mit den Piezoschichten 36 nicht möglich ist, da deren Materialeigenschaften zu unterschiedlich sind.

## Patentansprüche

1. Kraftstoffinjektor (10), insbesondere Common-Rail-Injektor, mit einem Injektorgehäuse (11), in dem ein Hochdruckraum (15) ausgebildet ist, der über eine im Injektorgehäuse (11) angeordnete Versorgungsbohrung (19) mit unter Druck stehendem Kraftstoff versorgbar ist, mit wenigstens einer zumindest mittelbar mit dem Hochdruckraum (15) verbundenen, im Injektorgehäuse (11) ausgebildeten Einspritzöffnung (12) zum Einspritzen von Kraftstoff in den Brennraum einer Brennkraftmaschine, mit einem die wenigstens eine Einspritzöffnung (12) freigebenden oder verschließenden Einspritzglied (16), und mit einer Messeinrichtung (30) zur zumindest mittelbaren Erfassung des Drucks im Hochdruckraum (15) oder der Versorgungsbohrung (19), wobei die Messeinrichtung (30) dazu ausgebildet ist, eine elastische Verformung eines zumindest mittelbar mit der Versorgungsbohrung (19) oder dem Hochdruckraum (15) in Wirkverbindung angeordneten Verformungsbereichs (27) des Injektorgehäuses (11) zu erfassen, wobei die Messeinrichtung (30) ein Piezoelement (31) aufweist, und wobei das Piezoelement (31) wenigstens zwei Elektrodenschichten (34, 35) mit dazwischen angeordneter Piezokeramikschicht (36) aufweist,
**dadurch gekennzeichnet,**
**dass** mehrere, vorzugsweise zwischen 10 und 100 übereinander angeordnete und parallel zueinander ausgerichtete Elektrodenschichten (34, 35) mit jeweils dazwischen angeordneten Piezokeramikschichten (36) vorgesehen sind, und dass die gegenüberliegenden Stirnseiten des Piezoelements (31) mit jeweils einer Isolationsschicht (37, 38) versehen sind.

2. Kraftstoffinjektor nach Anspruch 1,
**dadurch gekennzeichnet,**
**dass** die Elektrodenschichten (34, 35) gleicher Polarität jeweils mit einer gemeinsamen Anschlussleitung (41, 42) versehen sind.

3. Kraftstoffinjektor nach Anspruch 2,
**dadurch gekennzeichnet,**
**dass** die Elektrodenschichten (34, 35) gleicher Polarität im Verbindungsbereich zu den Anschlussleitungen (41, 42) in Bezug zu einer Längsachse (39) des Piezoelements (31) fluchtend zueinander ausgerichtet sind.

4. Kraftstoffinjektor nach einem der Ansprüche 1 bis 3,
**dadurch gekennzeichnet,**
**dass** die Dicke einer aus zwei Elektrodenschichten (34, 35) und dazwischen liegender Piezokeramikschicht (36) gebildeten Einheit zwischen 20µm und 300µm beträgt.

5. Kraftstoffinjektor nach einem der Ansprüche 1 bis 4,
**dadurch gekennzeichnet,**
**dass** das Piezoelement (31) eine runde, kreissegment- oder rechteckförmige Grundfläche bzw. einen entsprechenden Querschnitt aufweist.

6. Kraftstoffinjektor nach einem der Ansprüche 1 bis 5,
**dadurch gekennzeichnet,**
**dass** die Isolationsschichten (37, 38) aus demselben Grundmaterial wie die Piezokeramikschicht (36) oder aus Aluminiumoxid bestehen.

7. Verfahren zur Herstellung eines Piezoelements (31) für einen Kraftstoffinjektor (10) nach einem der Ansprüche1 bis 6, wobei das Piezoelement (31) mehrere, vorzugsweise zwischen 10 und 100 übereinander angeordnete und parallel zueinander ausgerichtete Elektrodenschichten (34, 35) mit jeweils dazwischen angeordneten Piezokeramikschichten (36) aufweist, und wobei die gegenüberliegenden Stirnseiten des Piezoelements (31) mit jeweils einer Isolationsschicht (37, 38) versehen sind,
**dadurch gekennzeichnet,**
**dass** die Piezokeramikschichten (36) aus ungebrannten Keramikfolien hergestellt werden, die mit den Elektrodenschichten (34, 35) versehen und mittels Bindemitteln in einem Laminierprozess übereinander gestapelt werden, und dass anschließend durch eine Wärmebehandlung eine Entfernung des Bindemittels und anschließend eine Versinterung der Piezokeramikschichten (36) erfolgt.

8. Verfahren nach Anspruch 7,
**dadurch gekennzeichnet,**
**dass** die Isolationsschichten (37, 38) zusammen mit den Piezokeramikschichten (36) der Wärmebehandlung unterzogen und mit dem Piezoelement (31) verbunden werden.
